(19) Europäisches Patentamt
European Patent Office
Office européen des brevets

(11) EP 4 660 863 A1

(12) **EUROPEAN PATENT APPLICATION**

(43) Date of publication:
10.12.2025 Bulletin 2025/50

(21) Application number: 25181500.7

(22) Date of filing: 06.06.2025

(51) International Patent Classification (IPC):
G06F 30/10 (2020.01)    G06T 17/10 (2006.01)

(52) Cooperative Patent Classification (CPC):
G06F 30/10; G06T 17/10; G06T 19/20

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH LA MA MD TN

(30) Priority: 07.06.2024 US 202418736700

(71) Applicant: Dassault Systemes Solidworks
Corporation
Waltham, MA 02451 (US)

(72) Inventors:
• Yu, Bowen
02451 Waltham (US)
• Lef, Isaac
02451 Waltham (US)
• Huang, Yunching
02451 Waltham (US)
• Stiles, Jody
02451 Waltham (US)

(74) Representative: Bandpay & Greuter
11, rue Christophe Colomb
75008 Paris (FR)

(54) **TRIM SURFACE WITH AUTOMATIC VOLUME GENERATION**

(57) An automatic volume generation method during trim setting of a modeled object receives geometric data for intersecting faces, computes intersecting curves, splits the faces along the curves, and merges manifold edges to create expanded shells. Shells with non-boundary edges are pruned, and minimum volumes formed by the pruned shells are identified and indicated on a graphical user display.

EP 4 660 863 A1

**EP 4 660 863 A1**

**Description**

<u>FIELD OF THE INVENTION</u>

The present invention relates to Computer Aided Design (CAD) for Product Design, and more particularly, is related to geometric modeling.

<u>BACKGROUND OF THE INVENTION</u>

Trim surface is a popular feature in many CAD software systems. The trim surface feature from typical CAD systems creates partitions of surfaces of a displayed modeled object. Surfaces of the modeled object may have intersections. When a surface is divided into smaller individual surfaces, a CAD system user can decide whether to keep or remove ("trim") smaller surfaces along the intersections. The trim surface feature identifies faces and edges of a modeled object, and stores geometric descriptions of the object and its faces and edges, for example, in descriptor tables in a database of the CAD system. Users often employ the trim surfaces feature to create one or more closed volumes. However, when a modeled object has many small surfaces to trim (for example, five or more surfaces), it may be confusing for the user to identify the desired surfaces among all the small surface sections because some may have overlap previews in a displayed depiction of the modeled object. Users may need more than one attempt or iterations to find all surfaces, which may be time consuming as well as confusing.

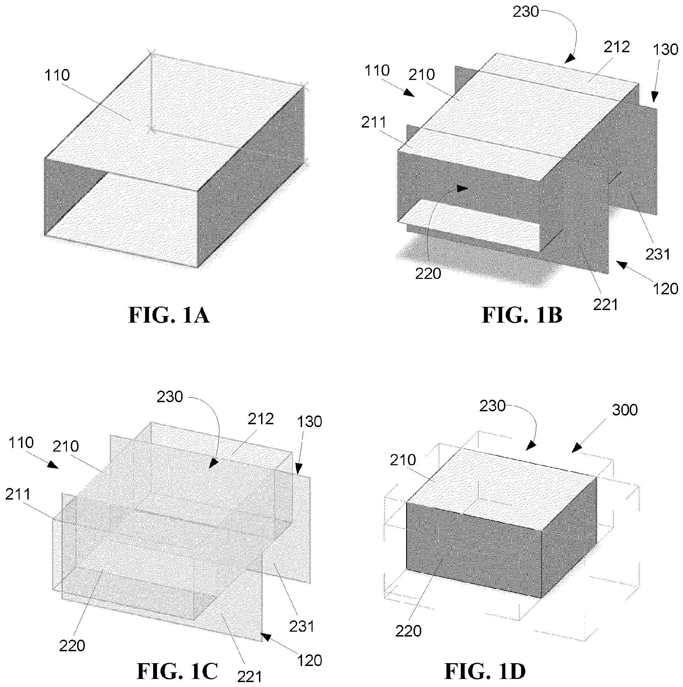

When two or more surfaces of a modeled object intersect, surfaces may be cut into pieces by intersection curves. The trim surface feature is used to remove unwanted pieces and keep the wanted pieces. Trimmed results may be knit together to define one or more volumes. For example, a rectangle is extruded to create an open first shell 110, as shown by FIG. 1A. As shown by FIGS. 1B, 1C, two lines are extruded to create two planar shells, a second shell 120 and a third shell 130. The second shell 120 and the third shell 130 intersect the first shell 110. The resulting intersection curves divide the shells 110, 120, 130 into smaller pieces. Here, the first shell 110 is cut into a central shell 210, and edge shells 211, 212. The two planar shells 120, 130 are cut into two pieces each, respectively interior pieces 220, 230, and surround pieces 221, 231. Through a trim surface feature, users can select the central shell 210 and interior pieces 220, 230 to keep and knit them into a closed shell 300, as shown by FIG. 1D. The closed shell 300 becomes a volumetric block after knit operation. While this example shows a relatively simple operation, a similar manual process can be tedious and error-prone when there are many faces to select or remove. Therefore, there is a need in the industry to address the aforementioned issues.

<u>SUMMARY OF THE INVENTION</u>

Embodiments of the present invention provide a method for automatic volume generation in a trim feature application of a CAD system. Briefly described, the present invention is directed to automatically generating volumes during trim setting of a modeled object. The method receives geometric data for intersecting faces, computes intersecting curves, splits the faces along the curves, and merges manifold edges to create expanded shells. Shells with non-boundary edges are pruned, and minimum volumes formed by the pruned shells are identified and indicated on a graphical user display.

Other systems, methods and features of the present invention will be or become apparent to one having ordinary skill in the art upon examining the following drawings and detailed description. It is intended that all such additional systems, methods, and features be included in this description, be within the scope of the present invention and protected by the accompanying claims.

<u>BRIEF DESCRIPTION OF THE DRAWINGS</u>

The accompanying drawings are included to provide a further understanding of the invention, and are incorporated in and constitute a part of this specification. The components in the drawings are not necessarily to scale, emphasis instead being placed upon clearly illustrating the principles of the present invention. The drawings illustrate embodiments of the invention and, together with the description, serve to explain the principles of the invention.

FIG. 1A is a schematic diagram of an exemplary shell from an extruded rectangle.
FIG. 1B shows the extruded rectangle of FIG. 1A intersected by two planes.
FIG. 1C shows a trim selection of surfaces of the intersected extruded rectangle of FIG. 1B.
FIG. 1D shows a volume resulting from the trim selection of FIG. 1C.
FIG. 2A is a schematic diagram showing four faces with laminar edges resulting from the trim of FIG. 1C.
FIG. 2B is detail of two faces of FIG. 2A.
FIG. 2C is detail of another two faces of FIG. 2A.

FIG. 3A is a first detail of the volume 300 FIG. 1D.

FIG. 3B is a second detail of the volume 300 FIG. 1D.

FIG. 3C is a third detail of the volume 300 FIG. 1D.

FIG. 4 is a flowchart of an exemplary shell creation method.

FIG. 5 is a flowchart of an exemplary shell pruning method.

FIG. 6A reproduces the schematic diagram of an exemplary shell from an extruded rectangle of FIG. 1A.

FIG. 6B shows a third plane added to the extruded rectangle of FIG. 2B.

FIG. 6C shows a trim selection of surfaces of the intersected extruded rectangle of FIG. 6B.

FIG. 6D shows two volumes resulting from the trim selection of FIG. 6C.

FIG. 7A is a schematic diagram showing six faces with laminar edges resulting from the trim of FIG. 6C.

FIG. 7B is detail of three faces of FIG. 6A.

FIG. 7C is detail of the remaining three faces of FIG. 6A.

FIG. 8A shows the two closed volumes if FIG. 6D.

FIG. 8B shows a first (rear) shell.

FIG. 8C shows a second (front) shell.

FIG. 8D shows a third shell separating the rear shell of FIG. 8B and the front shell of FIG. 8C.

FIG. 9 is a flowchart for an exemplary embodiment of the Finding Minimum Volumes sub-module.

FIG. 10 is a flowchart for an exemplary embodiment of the Candidate Shell Expansion sub-module.

FIG. 11 is a flowchart for an exemplary embodiment of the Volume Setting sub-module.

FIG. 12 is a flowchart summarizing the method for trimming surface with automatic volume generation.

FIG. 13 is a flowchart for an exemplary embodiment of a method for expansion for a first volume.

FIG. 14 is a flowchart for an exemplary embodiment of a method for expansion with a bounding volume.

FIG. 15 is a flowchart for an exemplary embodiment of a fast minimum volume search method.

FIG. 16A shows a coffee cup model.

FIG. 16B shows the model of FIG. 16A with one closed shell as the cup base.

FIG. 16C shows the model of FIG. 16A with one interior surface to cut the inside of the cup.

FIG. 17A shows the coffee cup model of FIG. 16A after faces have been split.

FIG. 17B shows an interior volume and an exterior volume from the split faces of FIG. 17A.

FIG. 17C shows the model of FIG. 17B with the interior volume removed.

FIG. 18A shows an example of a modeled part having four surfaces.

FIG. 18B shows partitions of the surfaces of the part of FIG. 18A.

FIG. 18C shows four volumes automatically generated from the partitioned surfaces of FIG. 18B.

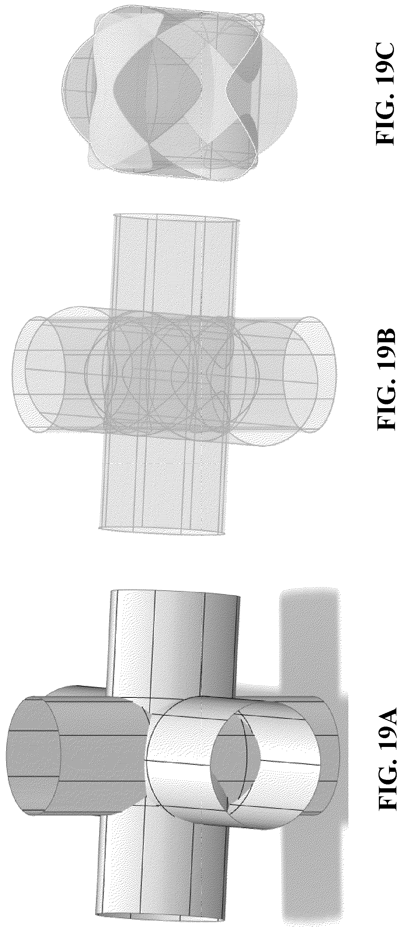

FIG. 19A shows a model of three cylindrical shells intersecting along x-, y-, and z-axes.

FIG. 19B shows the model of FIG. 19A after shells have been split.

FIG. 19C shows 8 volumes generated from the three intersecting cylindrical shells.

FIG. 20 is a schematic diagram illustrating an example of a system for executing functionality of the present invention.

## DETAILED DESCRIPTION

The following definitions are useful for interpreting terms applied to features of the embodiments disclosed herein, and are meant only to define elements within the disclosure.

As used within this disclosure, a "descriptor" refers to a data structure describing the properties of a local region of geometry within a modeled object in a CAD system. A descriptor may include both text fields and numerical fields, as well as fields indicating relationships with other components and/or structural features. This usage of the term 'descriptor' is common in information retrieval systems. For example, in image retrieval system, descriptors contain the visual features of images such as shape, color or texture that help classify images. In a music search system, a descriptor may contain properties such as rhythm, scale, genre, artists etc. In a document retrieval system, a descriptor may contain the counts of individual words, author, language etc.

As used within this disclosure, a "component list" refers to a listing of individual parts of a two dimensional (2D) or three dimensional (3D) modeled object. In a CAD environment, a component list may be presented visually as a side-bar to a graphical window presenting a 2D or 3D rendering of the modeled object. The component list and the graphical window may be interactive, for example, selecting a component in the component list may highlight the corresponding component in the graphical window, and likewise selecting a component in the graphical window (for example, via a mouse click) may highlight the corresponding component in the component list.

As used within this disclosure, a "face" refers to a surface of a part of a 2D or 3D modeled object. In general:

- Domain: The topological domain is a set of cells of same dimension connected between them
- Cell: This is a connected limitation of an underlying geometry.

- Vertex: is a 0 dimension cell underlyed to a geometrical point.
- Edge: is a cell underlyed to a curve (dim 1) and limited by points (dim 0)
- Face: is a cell underlyed to a surface (dim 2) and limited by edges (dim 1).
- Volume: is a cell underlyed to a Space (dim 3) and limited by Faces (dim 2)
- A Shell is a set of faces connected by edges bounding a volume or in the 3D Space.
- A Loop is a set of edges connected by vertices bounding a face.
- A Wire is a set of edges connected by vertices in the 3D space.

As used within this disclosure, a "volume" refers to a three-dimensional space entirely enclosed by one or more faces. For example, a sphere defines a volume enclosed by one face, a hemisphere defines a volume enclosed by two faces, a cylinder defines a volume enclosed by three faces, a pyramid defines a volume enclosed by four (triangular) or five faces (four triangles and one rectangle), and a cube defines a volume enclosed by six faces.

As used within this disclosure, for a group of shells that only intersect at boundary edges, a "minimum volume" refers to, a volume composed of some of the shells that cannot be divided by any of the other shells.

As used within this disclosure, given a group of shells that only intersect at boundary edges, a "maximum volume" refers to a volume that contains all the shells or no shells are outside the volume.

Given a group of shells that only intersect at boundary edges, as used within this disclosure, a "bounding volume" refers to a bounding volume is used as a boundary to separate the given shells into three groups-inside, on and outside.

As used within this disclosure, an "edge" refers to an extremity of a face, for example, a line segment joining two vertices in a polygon, polyhedron, or higher-dimensional polytope. In a polygon, an edge may be a line segment on the boundary, and is often called a polygon side. In a polyhedron or more generally a polytope, an edge is a line segment where two faces (or polyhedron sides) meet. An edge shared by only two faces is a manifold edge. An edge shared by more than two faces is a non-manifold edge. Laminar edges are boundary edges of faces. If a face has laminar edges, the face cannot be part of any volumes. Edges are laminar when they are owned by only one face.

As used within this disclosure, a "shell" refers to a set of faces connected by their respective edges, for example, bounding a volume in the 3D space.

As used within this disclosure, "extrude" means to extend a modeled line or face to add another dimension. For example, a line (one dimensional (1D)) may be extruded to form a rectangle (two dimensional (2D)). A circle (2D) can be extruded to form a cylinder, and rectangle (2D) may be extruded to form an open shell (three dimensional (3D)).

Reference will now be made in detail to embodiments of the present invention, examples of which are illustrated in the accompanying drawings. Wherever possible, the same reference numbers are used in the drawings and the description to refer to the same or like parts.

Exemplary embodiments of the present invention describe a method for enhancing a trim surface application to automatically remove trimmed surfaces and generate closed volumes. For example, when a generate volume option of the trim surface application is selected, an automatic volume generation module generates volumes resulting from the trim surface for a user to choose.

When two or more surfaces intersect, the surfaces are divided into smaller pieces (faces), for example, via application of a standard surface split algorithm of a CAD system. In terms of topology, a split divides large faces into smaller faces. In this document, edges are enclosed by vertices and represented by $E$; faces are enclosed by edges and represented by F and $EDGES(F) = \{E_1, E_2, ..., E_k\}$ is the set of edges of F. An edge E may be shared by one or more faces, i.e., $SHARED(E) = \{F_1, F_2, ...F_s\}$ or $E \in EDGES(F_1) \cap EDGES(F_2) \cap ... \cap EDGES(F_s)$. Edges are laminar when they are owned by only one face, i.e., $SHARED(E) = \{F\}$ and $E \in EDGES(F)$. In another word, the number of elements in $SHARED(E)$ is 1, i.e., $COUNT(SHARED(E)) = 1$. Laminar edges are boundary edges of faces. If a face has laminar edges, the face cannot be part of any volumes.

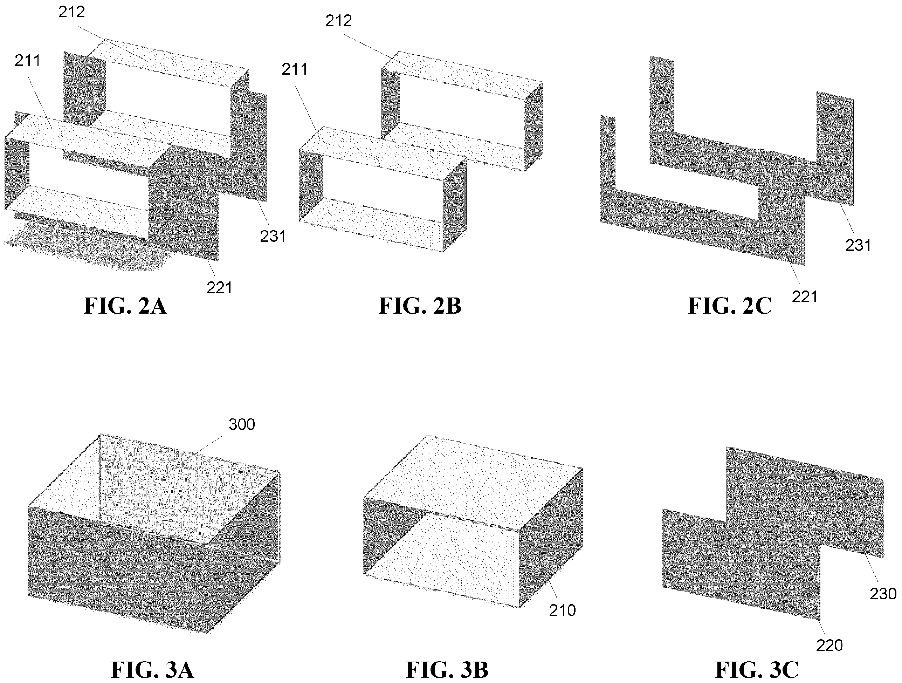

Continuing with the example shown in FIG 1B, as shown by FIG. 2A, after planar shells 120, 130 intersect the first shell 110, there are four faces 211, 212, 221, 231 with laminar edges. Edge shells 211, 212, shown in FIG. 2B, are from the first shell 110 (FIG. 1A). Surround pieces 221, 231, shown in FIG. 2C, are produced from cutting planar shells 120, 130 (FIG. 1B). Edge shells 211, 212 and surround pieces 221, 231 cannot be part of a volume, and may be removed. All the boundary edges of the central shell 210 (FIG. 1B) from the first shell 110 (FIG. 1A), and interior pieces 220, 230 (FIG. 1B) from the cutting planes 120, 130 (FIG. 1C) are adjacent to two faces or are shared by two faces, and hence may form the volume 300, as shown by FIG. 3A.

Faces are connected to form a shell which is a set of faces connected by edges bounding a volume in the 3D space. Herein, shells are represented by $S$ whose faces are $FACES(S) = \{F_1, F_2, .... F_m\}$ and edges are $EDGES(S) = \{E_1, E_2, .... E_n\}$. If an edge $E$ is shared by only two faces $F_1$ and $F_2$ i.e., $SHARED(E) = \{F_1, F_2\}$, $E \in EDGES(F_1) \cap EDGES(F_2)$ it is a manifold edge. If an edge is shared by more than two faces $COUNT(SHARED(E)) > 2$, it is a non-manifold edge.

After a standard trim surfaces split operation, there are small faces $\{F_1, F_2, ..., F_p\}$. Shells $\{S_1, S_2, ..., S_p\}$ may be constructed with each face such that $\forall S_i \in \{S_1, S_2, ..., S_p\}$, $FACES(S_i) = \{F_i\}$, $EDGES(S_i) = EDGES(F_i)$. For purposes of convenience the volume generation module of the present embodiment handles shells a unit. A shell can be expanded if it has manifold edges shared with another shell. Boundary edges of a shell are represented by $BOUNDARY(S) \subset EDGES(S)$, which is a subset of the shell edges. Manifold boundary edges are subset of boundary edges represented by $MANIFOLD(S) \subset BOUNDARY(S)$. Initially a shell $S$ contains only one face $FACES(S) = \{F\}$ and the boundary edges of the shell $BOUNDARY(S)$ is made up of all the edges of the face $F$, i.e., $BOUNDARY(S) = BOUNDARY(F)$. If two shells $S_1$ and $S_2$ share only manifold edges i.e. $\forall E \in BOUNDARY(S_1) \cap BOUNDARY(S_2)$, $E$ is a manifold edge, then they can be merged into one shell $S_3$ which contains all the faces and edges of the two merged shells i.e., $FACES(S_3) = FACES(S_1) \cup FACES(S_2)$ and $EDGES(S_3) = EDGES(S_1) \cup EDGES(S_2)$. The new boundary edge set is all the boundary edges that do not share with $S_1$ and $S_2$, i.e.,

$$BOUNDARY(S_3) = (BOUNDARY(S_1) \cup BOUNDARY(S_2)) - (BOUNDARY(S_1) \cap BOUNDARY(S_2)).$$

Similarly, the manifold edges are

$$MANIFOLD(S_3) = (MANIFOLD(S_1) \cup MANIFOLD(S_2)) - (MANIFOLD(S_1) \cap MANIFOLD(S_2)).$$

Eq.1 summarizes the result of merging two shells $S_1$ and $S_2$ into a single shell $S_3$:

$$\begin{cases} FACES(S_3) = FACES(S_1) \cup FACES(S_2) \\ EDGES(S_3) = EDGES(S_1) \cup EDGES(S_2). \\ BOUNDARY(S_3) = \big(BOUNDARY(S_1) \cup BOUNDARY(S_2)\big) \\ \quad -\big(BOUNDARY(S_1) \cap BOUNDARY(S_2)\big) \\ MANIFOLD(S_3) = \big(MANIFOLD(S_1) \cup MANIFOLD(S_2)\big) \\ \quad -\big(MANIFOLD(S_1) \cap MANIFOLD(S_2)\big) \end{cases} \quad \text{Eq. 1}$$

A shell creation module identifies the largest possible shells, that is, shells whose boundary edges are either laminar or non-manifold, i.e., $MANIFOLD(S) = \emptyset$.

Here, the shell creation algorithm expands one shell by merging with the adjacent shells across manifold edges to yield a larger shell. This process is repeated until all boundary edges are non-manifold edges or laminar edges. These steps are repeated for the rest of the faces until all faces are visited.

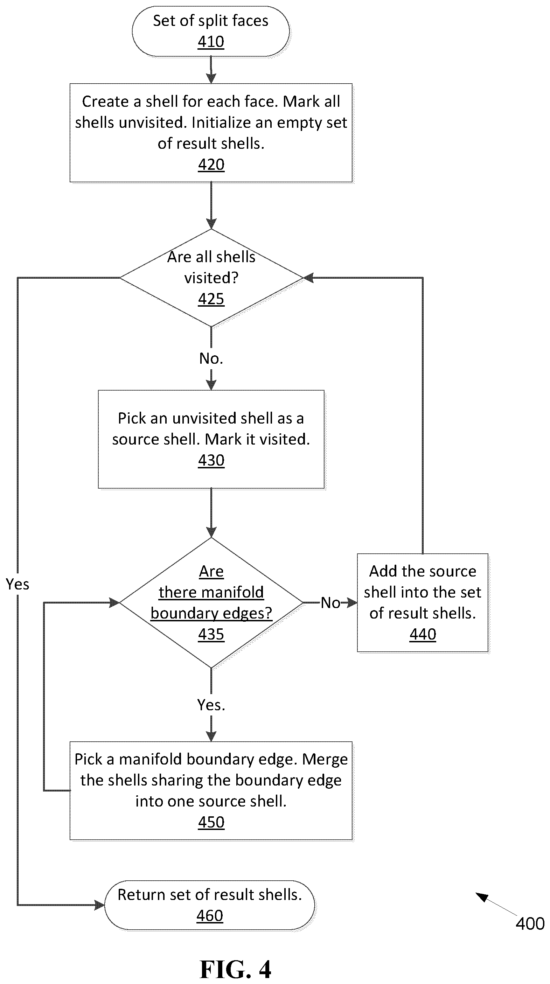

FIG. 4 is a flowchart 400 of an exemplary method of shell creation. It should be noted that any process descriptions or blocks in flowcharts should be understood as representing modules, segments, portions of code, or steps that include one or more instructions for implementing specific logical functions in the process, and alternative implementations are included within the scope of the present invention in which functions may be executed out of order from that shown or discussed, including substantially concurrently or in reverse order, depending on the functionality involved, as would be understood by those reasonably skilled in the art of the present invention.

A set of split faces is received, as shown by block 410, for example, from a trim surface module. A plurality of $p$ shells $\{S_1, S_2, ..., S_p\}$ are created for all the faces $\{F_1, F_2, ..., F_p\}$ to merge, as shown by block 420. One shell per face $FACES(S_i) = \{F_i\}$, $EDGES(S_i) = EDGES(F_i)$, $i = 1,2, ..., p$. All shells are marked as unvisited, i.e., $VISIT(S_i) = false$, $i = 1,2, ..., p$. An empty set $L_S = \emptyset$ is created to track resulting shells.

When all shells have been visited, the process proceeds to block 460, as shown by block 425. Otherwise, an unvisited shell $S_i$ of the plurality of shells is picked as a source shell and marked as visited, $VISITED(S_i) = true$, as shown by block 430.

All manifold boundary edges of the source shell are found, i.e., $MANIFOLD(S_i) \subset BOUNDARY(S_i)$. As shown by block 435, if there are no manifold boundary edges, i.e., $MANIFOLD(S_i) = \emptyset$, the source shell is added to the set of result shells, i.e., $L_S = L_S \cup \{S_i\}$, as shown by block 440, and processing returns to block 425. If there are manifold boundary edges of the source shell, a manifold boundary edge of the source shell $E \in$

$MANIFOLD(S_i)$ is picked, as shown by block 450. Here, the picked boundary edge $E$ is shared by the source shell $S_i$ and another unvisited shell $S_j$. The two shells $S_i$ and $S_j$ are merged into one source shell $S_i = S_i \cup S_j$ such that

$$\begin{cases} FACES(S_i) = FACES(S_i) \cup FACES(S_j) \\ EDGES(S_i) = EDGES(S_i) \cup EDGES(S_j). \\ BOUNDARY(S_i) = \big(BOUNDARY(S_i) \cup BOUNDARY(S_j)\big) \\ \qquad - \big(BOUNDARY(S_i) \cap BOUNDARY(S_j)\big) \\ MANIFOLD(S_i) = \big(MANIFOLD(S_i) \cup MANIFOLD(S_j)\big) \\ \qquad - \big(MANIFOLD(S_i) \cap MANIFOLD(S_j)\big) \end{cases} \qquad \text{Eq. 2}$$

The (previously) unvisited shell is marked as visited $VISITED(S_j) = true$. When all shells have been visited, the set of result shells $L_S$ is returned, as shown by block 460.

Upon completion of the exemplary method of shell creation of FIG. 4, no shells in $L_S$ have manifold boundary edges after the shell creation algorithm, i.e., $\forall S \in L_S, MANIFOLD(S) = \varnothing$. Shells can have laminar edges or non-manifold boundary edges. If a shell has laminar edges, then it cannot become closed, and thus may be removed from consideration for volume checking.

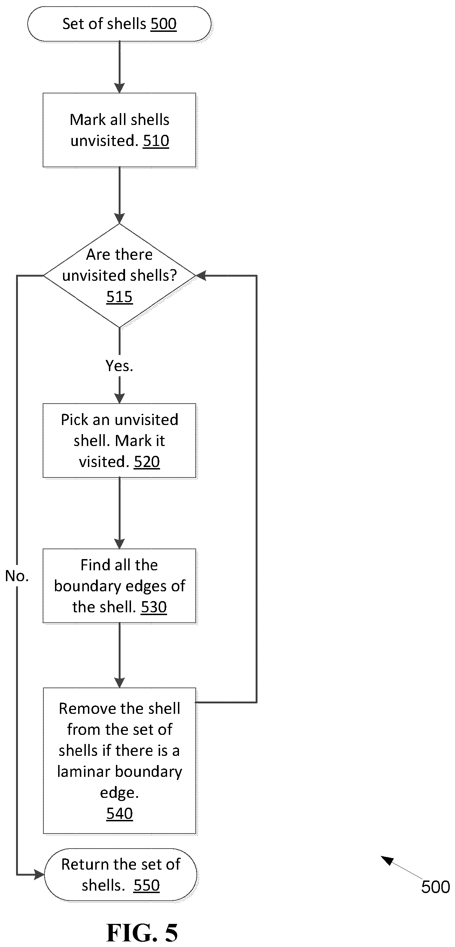

FIG. 5 is a flowchart 500 of an exemplary embodiment of a shell pruning module. The shell pruning module removes shells that either have no boundary edges or have laminar edges. A set of shells is received, as shown by block 500. All shells are initially marked unvisited ($\forall S \in L_S, VISITED(S) = false$), as shown by block 510. If there are unvisited shells (tested at block 515), an unvisited shell $S \in L_S$ is picked from the shell set, as shown by and the shell is marked as visited i.e., $VISITED(S) = true,$ as shown by block 520. If the shell has a laminar boundary edge, the shell remove it from the set ($\exists E \in BOUNDARY(S), COUNT(SHARED(E)) = 1$, then $L_S = L_S - \{S\}$) as shown by block 540, and the process returns to block 515. If there are no unvisited shells, the updated set of shells $L_S$ is returned, as shown by block 550.

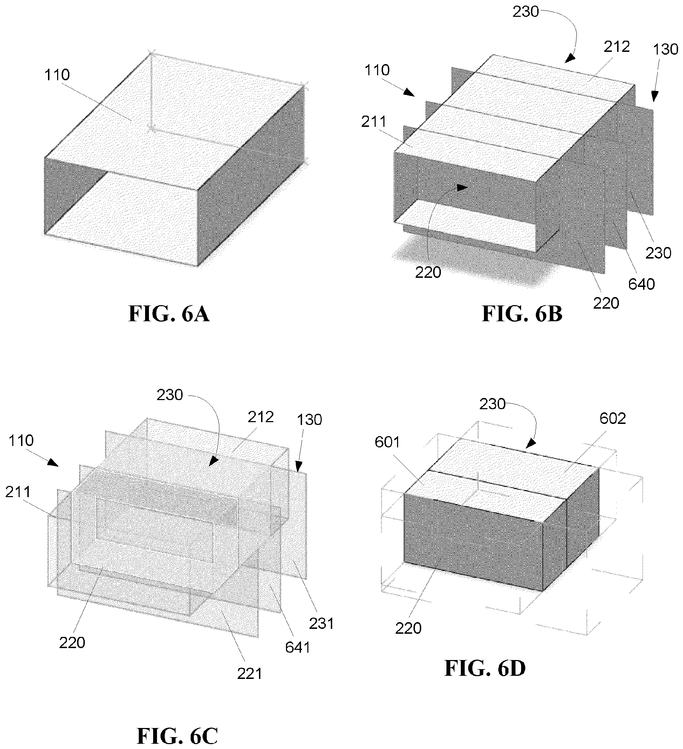

FIGS. 6A-6D extend the example of FIGS. 1A-1D by adding a third planar shell 640 to cut the shell 110. While the example of FIGS. 1A-1D produced one volume, here two volumes are produced. FIG. 6A shows the shell 110 formed from the extruded rectangle. FIG. 6B adds a third vertical planar shell 640 between the first and second shells 220, 230. FIG. 6C illustrates the shells picked during the trim operation. Here, the first shell is cut into four pieces. Each of the second, third and fourth shells is divided into two pieces. FIG. 6D shows two closed shells 601, 602 resulting from the trim.

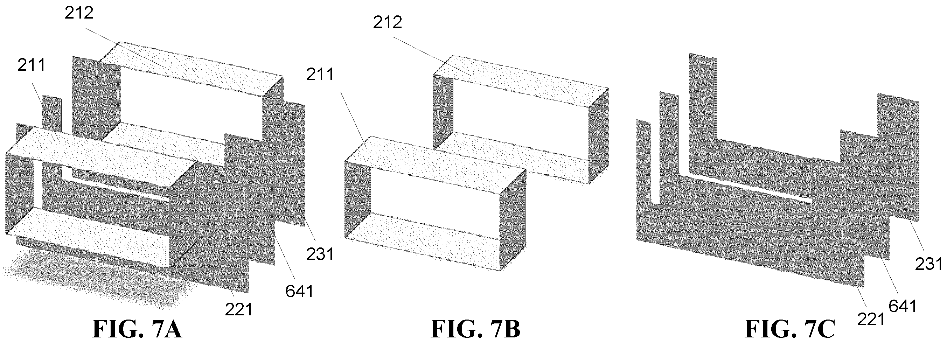

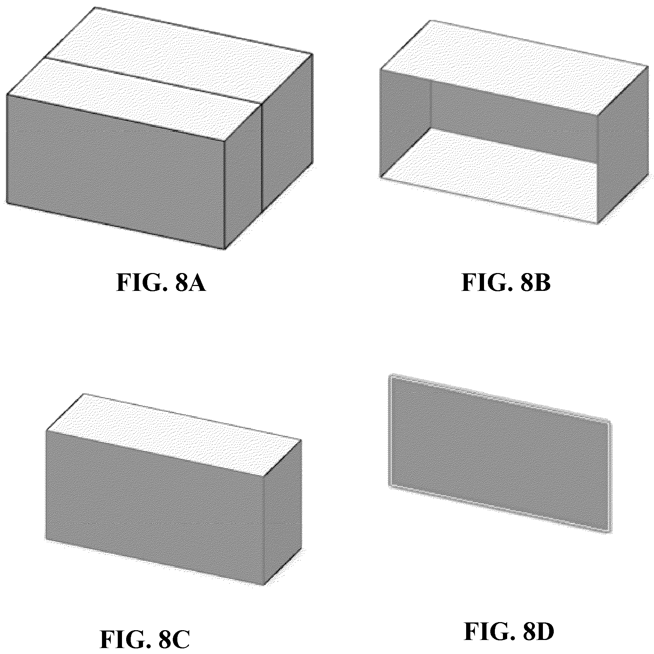

As before, shells with laminar edges 211,212, 221, 231, 261 (FIGS. 7A-7C) are removed. There are three shells with non-manifold boundary edges which can be elements for volumes (FIGS. 8A-8D). Any two of the three shells 220, 230, 640 can form a closed shell and thus a volume. FIG. 8A shows the two closed volumes, FIG. 8B shows a first (rear) shell), FIG. 8C shows a second (front) shell, and FIG. 8D shows a third shell separating the rear shell and the front shell.

This is an example of multiple volumes expanding from one shell. Here, the user may select which volumes to keep. Just like trimmed surfaces, small non-overlapped volumes that are divided by shells are kept for users to choose. A shell has two sides (left and right). Each shell can be at most shared by two small non-overlapped volumes. For one shell, after expansion, in some scenarios (not shown) there may be multiple volumes on each side of the shell. On each side, only the one with the smallest volume is kept.

There are no unique shell expansions along non-manifold edges as they are shared by more than two shells. The embodiments check all neighbors of a shell to find an expansion.

The most straightforward way to find closed shells is brutal force method, by finding all shells and then finding all possible combinations of the shells to find volumes. The cost of the brute force method is exponentially related to the number of shells: for n shells there are $2^n$ possible combinations to check. The following describes a more efficient approach of finding minimum volumes.

After shell creation (by expansion across manifold edges) and shell pruning have been applied, the remaining shells are volume shells with either no boundary edges or non-manifold boundary edges: $\forall S \in L_S, BOUNDARY(S) = \varnothing$, or $\forall E \in BOUNDARY(S), then\ COUNT(SHARED(E)) > 2$. These shells are used by a find minimum volumes module.

If a shell S has no boundary edges at all i.e., $BOUNDARY(S) = \varnothing$, it is a volume shell. A volume is represented by $V = VOLUME(\{S\})$, a set of volumes are represented by $L_V$ which are for user selections i.e., $L_V = L_V \cup \{V\}$. If a source shell $S \in L_S$ has boundary edges, then the minimum volume module performs an expansion. This expansion is similar to the shell creation algorithm expanded from one face. Unlike shell creation expansion, here there may be multiple volumes expanded from one shell, and one shell may be used for expansions of other shells. If a shell is already expanded, the minimum volume modules removes the shell from the set of source shells $L_S = L_S - \{S\}$ so that expansions of other shells will not use it. When there are no shells left in $L_S$ i.e., $L_S = \varnothing$, all valid volumes have been found.

To find a minimum volume from one source shell $S \in L_S$, an empty set $L_C = \varnothing$ is created to keep track of candidate shells used for expansion. The source shell $S \in L_S$ is the first element of the set of candidate shells $L_C = \{S\}$. The set of candidate shells is considered as if it is one big shell having boundary edges $BOUNDARY(L_C)$ and non-boundary edges or internal edges $INTERNAL(L_C)$. Expansion is recursive across the boundary edges to add shells one by one into the candidate set $L_C$.

Across one exemplary boundary edge $E \in BOUNDARY(L_C)$, are adjacent shells sharing the boundary edge the edge with the source shell $ADJACENT(E) = (SHARED(E) - L_C) \cap L_S$. These adjacent shells are exclusive for subsequent expansion. Each of these adjacent shells represents an independent expansion when added to the candidate set $L_C$. Since there are multiple adjacent shells sharing the edge $E$, there are multiple possible expansions across the edge $E$, not all of which are valid expansions.

Boundary edges of adjacent shells may lie on the internal edges of the set of candidate shells $L_C$ i.e., $\forall S_a \in ADJACENT(E), BOUNDARY(S_a) \cap INTERNAL(L_C) = \emptyset$. These shells form non-manifold edges in the internal edges $BOUNDARY(S_a) \cap INTERNAL(L_C)$ and are thus invalid for expansions. Expansion is only done on the shells without internal intersections, i.e.,

$$VALIDADJACENT(E) = \{S | S \in ADJACENT(E), BOUNDARY(S) \cap INTERNAL(L_C) = \emptyset\}$$

$$(\text{Eq. 3})$$

When $L_C$ is expandable across a boundary edge $E \in BOUNDARY(L_C)$ with a shell $S_a \in VALIDADJACENT(E)$, the Eq. 4 is the equation to update boundary edges of the set of candidate shells.

$BOUNDARY(L_C \cup \{S_a\}) = (BOUNDARY(L_C) \cup BOUNDARY(S_a)) - (BOUNDARY(L_C) \cap BOUNDARY(S_a))$.
(Eq. 4)

$$(\text{Eq. 4})$$

And Eq. 5 is the equation to update internal edges of the set of candidate shells.

$$INTERNAL(L_C \cup \{S_a\}) = \Big(INTERNAL(L_C) \cup \big(BOUNDARY(L_C) \cap BOUNDARY(S_a)\big)\Big) \quad (\text{Eq. 5})$$

The module repeats this to continue the expansion by adding one shell at a time as long as expandable boundary edges remain. When there are no boundary edges ($BOUNDARY(L_C) = \emptyset$), the set of candidate shells $L_C$ can form a volume V.

When a volume is found, or $L_C$ is not expandable across an edge failing **Error! Reference source not found.**, expansion returns to the previous expansion state to check other adjacent shells or other expansions across the last used boundary edge. If $S_a E L_C$ is removed from $L_C$ i.e., $L_C = L_C - \{S_a\}$. The boundary edges and internal edge shrink.

$BOUNDARY(L_C - \{S_a\}) = (BOUNDARY(L_C) \cup BOUNDARY(S_a)) - (BOUNDARY(L_C) \cap BOUNDARY(S_a))$
(Eq. 6)

$$(\text{Eq. 6})$$

$$INTERNAL(L_C - \{S_a\}) = INTERNAL(L_C) - BOUNDARY(S_a) \quad (\text{Eq. 7})$$

Note that the boundary edge update expression is same for both expanding and shrinking. Expansion from one source shell is recursive and is applied to all source shells. If expansion is completed for a source shell, then the module removes it from the source set so that expansion for other shells will not use it, i.e., $L_S = L_S - \{S\}$.

Once a volume V is found expanded from a source shell $S$ ($V = VOLUME(L_C)$, $SHELLS(V) = L_C$), the side of the initial source shell $S$ this volume belongs to is determined. Since a shell has two sides, there may be multiple volumes expanded from one shell $S \in L_S$. When a shell is part of a volume boundary, a first side ("left side") may be inside the volume and a second side ("right side") outside. Here, volumes may be categorized as left side or right side with respect to the source shell. If the left side of the shell S is towards the inside of the volume V, then the volume V is on left side of shell S i.e., $LEFT(S) = LEFT(S) \cup \{V\}$; otherwise the volume V is on the right side of shell S or $RIGHT(S) = RIGHT(S) \cup \{V\}$. In this application, only the smallest volume on each side of a shell is presented to users to pick which should be kept in, as a result the left minimum volume is $MINLEFT(S) = \min\{LEFT(S)\}$ and right minimum volume is $MINRIGHT(S) = \min\{RIGHT(S)\}$.

Note that the minimum volume is also the minimum for all the shells enclosing the volume V not just for the source shell S, i.e.,

$$\forall S_V \in SHELLS(V), MINLEFT(S_V) = \begin{cases} MINLEFT(S), & when \ MINLEFT(S) \in LEFT(S_V) \\ MINRIGHT(S), & when \ MINRIGHT(S) \in LEFT(S_V) \end{cases},$$

$$MINRIGHT(S_V) = \begin{cases} MINLEFT(S), & when \ MINLEFT(S) \in RIGHT(S_V) \\ MINRIGHT(S), & when \ MINRIGHT(S) \in RIGHT(S_V) \end{cases}.$$

When a shell has two volumes already, the shell can be removed from the shell set for the subsequent volume search, i.e., set $L_S = L_S - \{S_C\}$.

The Finding Minimum Volumes module includes a Candidate Shell Expansion sub-module and a Volume Setting sub-module. Minimum volumes are found by navigating through all source shells $\forall S \in L_S$ for expansion. Candidate Shell Expansion checks all valid candidate expansions of $L_C$ from one source shell $S \in L_S$. Candidate Shell Expansion recursively calls itself for subsequent expansions until all possible expansions for minimum volumes are visited. When a volume $V = VOLUME(L_C)$ is found, the Volume Setting identifies the sides of the volume with respect to an input shell and set minimum volume to *MINLEFT(S)* and *MINRIGHT(S).*

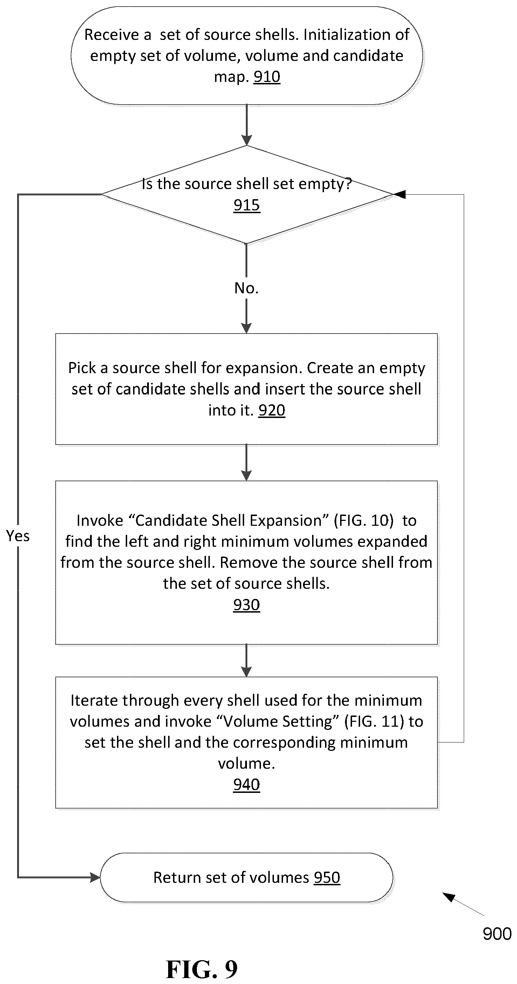

FIG. 9 is a flowchart 900 for an exemplary embodiment of the Finding Minimum Volumes sub-module. A set of source shells $L_S$ is received, as shown by block 910. An empty set of result volumes $L_V = \varnothing$ is created and initialized. Create an empty map of volume to its candidate shells *SHELLS(V)* = $\varnothing$ is created and initialized. An empty map is created and initialized to record the minimum left and right volumes of each shell $\forall S \in L_S$, MINLEFT (S) = $\varnothing$, MINRIGHT (S) = $\varnothing$.

At block 915, the set of source shells is checked. If the set of source shells is not empty (i.e., $L_S \neq \varnothing$), the sub-module proceeds to block 920 to traverse the shell set $L_S$. The sub-module picks a source shell $S \in L_S$ and prepares for expansion by creating an empty candidate set $L_C = \varnothing$ to record all the candidate shells for a volume. The source shell is inserted into the candidate set ($L_C = \{S\}$), and the boundary edges and internal edges of $L_C$ are set, such that *BOUNDARY* $(L_C)$ = *BOUNDARY(S)* and *INTERNAL($L_C$)* = *INTERNAL(S)*.

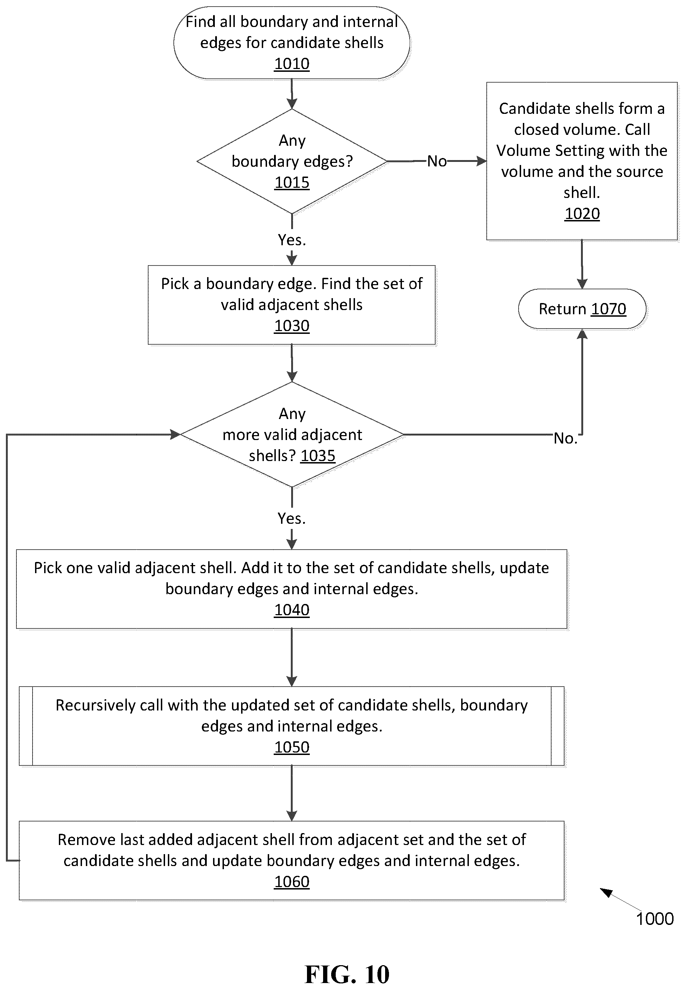

The "Candidate Shell Expansion" sub-module (FIG. 10) is invoked for the source shell $S$ with candidate set $L_C$, boundary edges *BOUNDARY($L_C$)* and internal edges *INTERNAL($L_C$)*, as shown by block 930. Here, the sub-process finds minimum volumes for left and right sides of the source shell $S$ i.e., *MINLEFT(S)* and *MINRIGHT(S)* and the candidate shells enclosing the volume *SHELLS(V) = $L_C$*. Minimum volumes are added to the result volume set $L_V = L_V$ U *{MINLEFT(S), MINRIGHT(S)},* and the shell $S$ is removed from the source set $L_S = L_S - \{S_V\}$.

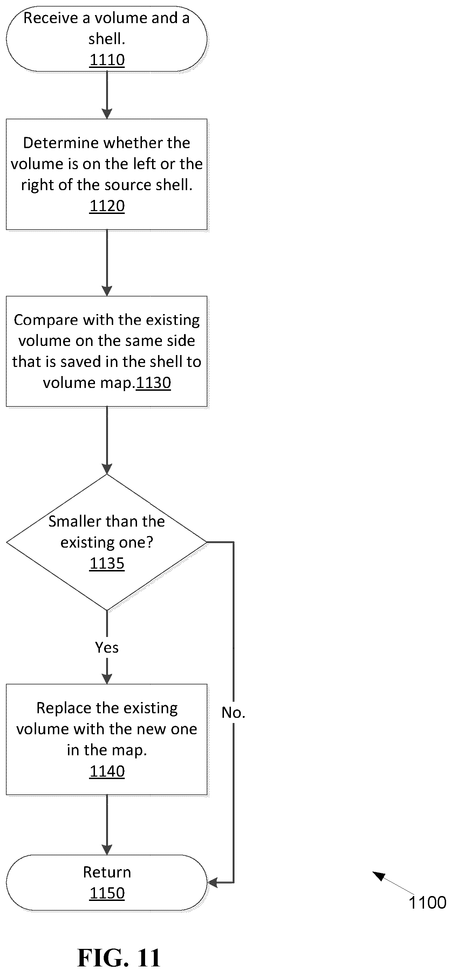

As shown by block 940, for each of the minimum volumes *MINLEFT(S)* and *MINRIGHT(S)* expanded from the source shell $S$, the sub-module walks through every shell for which the volumes *MINLEFT(S)* and *MINRIGHT(S)* are composed of i.e., $\forall S_V E \ SHELLS(MINLEFT(S))$ and $\forall S_v \in SHELL(MINRIGHT(S))$, and calls "Volume Setting" (see FIG. 11) with the shell $S_V$ and volume *MINLEFT(S)* or *MINRIGHT(S)*. After "Volume Setting", if $S_V$ has both minimum volumes, $S_V$ is removed from the source set $L_S$, i.e., if *MINLEFT($S_V$)* $\neq \varnothing$, *MINRIGHT($S_V$)* $\neq \varnothing$, then set $L_S = L_S - \{S_V\}$. The process returns to block 915. If no source shells are left *($L_S = \varnothing$),* the sub-process returns the volume set $L_V$.

FIG. 10 is a flowchart 1000 for an exemplary embodiment of the Candidate Shell Expansion sub-module. The Candidate Shell Expansion sub-module receives the source shell $S \in L_S$ and the current candidate set $L_C$ with boundary edges *BOUNDARY($L_C$)* and internal edges *INTERNAL($L_C$)* $\neq \varnothing$, as shown by block 1010, and checks for boundary edges, as shown by block 1015. If there are no boundary edges *(BOUNDARY($L_C$) = $\varnothing$)*, the candidate shells $L_C$ can form a closed shell and a volume $V = VOLUME(L_C)$, *SHELLS(V) = $L_C$*, as shown by block 1020. The Volume Setting algorithm is invoked with the volume $V$ and the source shell S, and the sub-module exits, as shown by block 1070. If there are boundary edges i.e., *BOUNDARY($L_C$) $\neq \varnothing$*, the sub-module selects a boundary edge of one of the candidate shells $E \in BOUNDARY(L_C)$ and finds all the valid adjacent shells from the current source shell *VALIDADJACENT(E),* as shown by block 1030.

As per block 1035, if there are no valid adjacent shells *(VALIDADJACENT (E) = $\varnothing$)*, the sub-module returns, as shown by block 1070. Otherwise, the sub-process selects valid adjacent shell from $S_a E \ VALIDADJACENT(E)$ to add to the candidate set $L_C = L_C$ U $\{S_a\}$, as shown by block 1040. Boundary edges are updated as per **Error! Reference source not found.** and internal edges are updated as per Eq. 5. As shown by block 1050, the Candidate Shell Expansion sub-module recursively calls itself with the source shell S, updated candidate set $L_C$, and updated boundary edges and updated internal edges. As shown by block 1060, the sub-module removes the adjacent shell $S_a$ from the valid adjacent set *VALIDADJA-CENT(E) = VALIDADJACENT(E) - $\{S_a\}$*, removes the added adjacent shell $S_a$ from the candidate set $L_C$ i.e. $L_C = L_C - \{S_a\}$, and updates boundary edges with **Error! Reference source not found.** and internal edges with **Error! Reference source not found..** The processing continues to block 1035 to process the next adjacent shell.

FIG. 11 is a flowchart 1100 for an exemplary embodiment of the Volume Setting sub-module. An input volume $V$ and a source shell $S$ are received, as shown by block 1110. The location of the volume is determined with respect to the source shell, as shown by block 1120. If the left side of the shell $S$ is the inside of the volume then the volume V is on the left of the shell $S$ i.e. *LEFT(S) = LEFT(S)* U *{V}*, otherwise the volume $V$ is on the right side of $S$ i.e., *RIGHT(S) = RIGHT(S)* U *{V}*. The volume value of $V$ i.e., *VALUE(V)* is calculated and compared with the current minimum volume, as shown by block 1130 Update the minimum volume of the shell S is updated. As shown by block 1135 if $V \in LEFT(S)$ and $VALUE(V) < VALUE(MINLEFT(S))$, then $MINLEFT(S) = V$, as shown by block 1140. If $V \in RIGHT(S)$ and $VALUE(V) < VALUE(MINRIGHT(S))$, then $MINRIGHT(S) = V$. The sub-module returns when all the shells have the associated volumes or have been used as source shells.

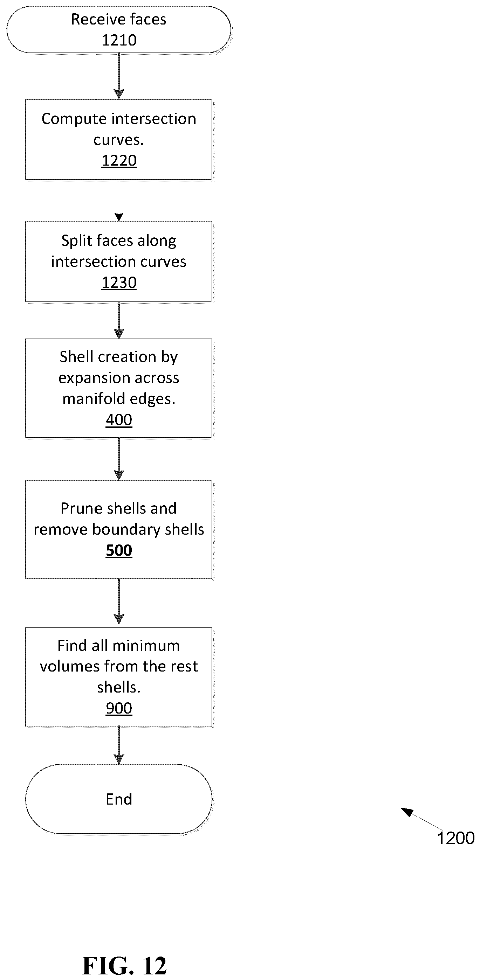

FIG. 12 is a flowchart 1200 for an exemplary method embodiment for automatic volume generation during a trim feature operation. A plurality of faces of a modeled geometrical object are received, as shown by block 1210. The plurality of faces are split along intersection curves, as shown by block 1220. Faces are merged into shells across manifold edges, as shown by block 400 (expanded in FIG. 4). The shells that have laminar boundary edges are removed as they cannot be part of any volumes, as shown by block 500 (expanded in FIG. 5). Minimum volumes are found as shown by block 900 (expanded in FIG. 9) to obtain all the result volumes for presentation to users.

Expansions may be larger or smaller each time a shell is added. The previously described method steps through all the volumes to determine the minimum volumes. Volume creation and calculation take majority of the time. The time complexity of volume creation is potentially exponential with the number of source shells. This following is a second embodiment that uses more geometry information to reduce the number of volume creations/comparisons.

Candidate shells are the result of split operations, and only connect on the shell boundaries. There are no intersections across shells. If a first found volume is found through a shell expansion, some of the shells are used as boundaries of the first found volume, and all the other shells are either inside the volume or outside the first found volume. The first found volume must contain a minimum volume of the source shell whose boundary shells must be inside the first found volume, so no shells outside of the first found volume need to be added. The first found volume can be used as a bounding volume that defines the scope of the candidate shells. This approach can greatly reduce the number of shells to search and/or the number of volumes to check. Note that checking if a shell is on a volume is trivial because this information is kept when a volume is generated *(SHELLS(V))*. Other shells are either inside or outside the volume. Alternative embodiments may check if a shell is inside a volume. One simple and practical way is to check if an interior point on a shell is inside a volume, which means the whole shell must be inside the volume.

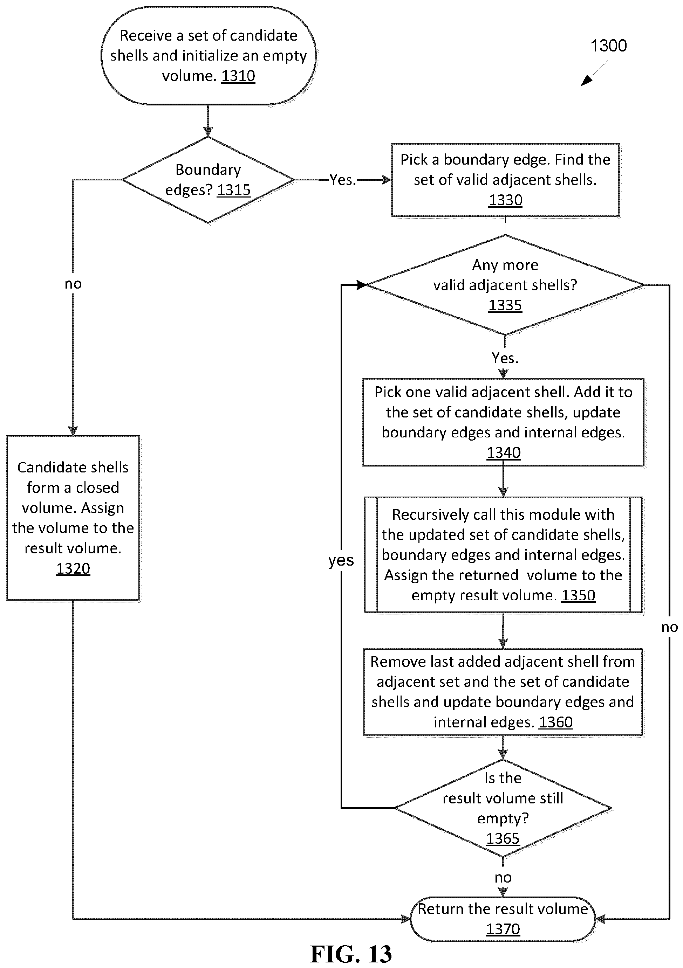

Given a source shell $S \in L_S$, the first step is to find a first volume $V_1$ by a modified version of Candidate Shell Expansion which returns as soon as the first volume is found. One of the two minimum volumes must be inside the first volume $V_1$, which is used as a bounding volume afterwards $V_b = V_1$. This modified expansion method is called Expansion for First Volume, and may be implemented as a software module. FIG. 13 is a flowchart 1300 for an exemplary embodiment of a method for expansion for a first volume.

The module receives a source shell $S \in L_S$, a current candidate set $L_C$, a boundary edge set $BOUNDARY(L_C)$, and an internal edge set $INTERNAL(L_C)$, and initializes an empty result volume $V$, as shown by block 1310. The module determines whether there are any boundary edges, as shown by block 1315.

If there are no boundary edges, i.e., $BOUNDARY(L_C) = \emptyset$, then the candidate shells $L_C$ can form a closed shell and set the result volume $V = VOLUME(L_C)$, $SHELLS(V) = L_C$, as shown by block 1320, and the module returns the result volume, as shown by block 1370. Returning to block 1315, if there are boundary edges ($BOUNDARY(L_C) \neq \emptyset$), a boundary edge $E \in BOUNDARY(L_C)$ is selected, and all the valid adjacent shells $VALIDADJACENT(E)$, are found, as shown by block 1330. The module determines whether there are any valid adjacent shells, as shown by block 1335.

If there are no valid adjacent shells $VALIDADJACENT(E) = \emptyset$, the module returns the result volume, as shown by block 1370. Otherwise, an adjacent shell $S_a \in VALIDADJACENT(E)$ is picked and added to the candidate set $L_C = L_C \cup \{S_a\}$, as shown by block 1340, whereupon boundary edges are updated with **Error! Reference source not found.** and internal edges are updated with **Error! Reference source not found.**.

The module recursively call itself with the source shell $S$ updated candidate set $L_C$ and updated boundary edges and updated internal edges, as shown by block 1350, and assign the returned result to the result volume $V$.

The adjacent shell $S_a$ is removed from the adjacent set $VALIDADJACENT(E) = VALIDADJACENT(E) - \{S_a\}$, as shown by block 1360. The added adjacent shell $S_a$ is removed from the candidate set $L_C$ i.e., $L_C = L_C - \{S_a\}$, boundary edges are updated with Eq. 6, and internal edges are updated with **Error! Reference source not found.**. The module checks if the volume $V$ is empty, as shown by block 1365. If volume $V$ is not empty, the module returns the result volume, as shown by block 1370. If volume $V$ is empty, control returns to block 1335 to process the next adjacent shell.

Once the first volume has been found, shell expansion is restarted from the source shell $S$ using only valid adjacent shells that are inside the bounding volume, i.e., *For a* $E \in BOUNDARY(L_C)$, $S_a \in VALIDADJACENT(E) \cap INSIDE(V_b)$ and on the volume, i.e., *For a* $E \in BOUNDARY(L_C)$, $S_a \in VALIDADJACENT(E) \cap SHELLS(V_b)$. The shells inside the bounding volume are used first. If it is not possible to find a volume, shells on the bounding volume are used. Any shells outside the bounding volume are not used for volume expansion. If the second volume $V_2$ is the same as the first bounding volume $V_b$, the first bounding volume is one of the minimum volume expanded from the source shell $S$. If a second volume is found inside the first volume, the second volume must be a smaller volume and can be used as a new bounding volume. The same process can be applied to find a third volume, a fourth volume and so on until no smaller volumes can be found. All the volumes found this way are on the same side of the source shell $S$. The last volume is a minimum volume of shell $S$.

If there are two minimum volumes expanded from the shell S, the shells of the other minimum volume must be outside the first bounding volume $V_1$. To find the minimum volume on the other side of the source shell, a bounding volume is sought on the other side of the source shell S, which is also outside the first bounding volume $V_1$. Similar to the process of finding the first minimum volume, shell expansion is restarted using only shells outside of the bounding volume $V_b = V_1$ i.e.,For a E $\in$ BOUNDARY($L_C$), $S_a$ E VALIDADJACENT(E) $\cap$ OUTSIDE($V_b$) or on the bounding volume For a E $\in$ BOUNDARY($L_C$), $S_a$ E VALIDADJACENT(E) $\cap$ SHELLS($V_b$). The shells outside are prioritized above before the shells on the bounding volume. The shell expansion stops as soon as the second volume $V_2$ is found. If the second volume $V_2$ is the same as the first bounding volume $V_b$, then the bounding volume $V_b$ is the largest volume with shells that all have only one minimum volumes. If the second volume is different from the first volume, determine if the second volume is on the other side of the source shell. If the second volume is on the other side of the shell, then the second volume can be used as a bounding volume for searching for the second minimum volume which is same process as finding the first minimum volume. If the second volume is not on the other side, the second volume may be used as a new bounding volume $V_b = V_2$ to search for a volume outside the bounding volume. This repeats until either a volume on the other side of the source shell S is found, or no more volumes are available, and the last volume is the largest volume that can be found from the source shell. All shells on the largest volume have only one minimum volume. When these shells are used as source shells, only one minimum volume can be found.

Based on the above discussion, when there is a bounding volume, expansion of shell expansion may take two directions: expand with shells inside or on the bounding volume; expand with shells outside or on the bounding volume. These two cases are combined here into one "expansion with bounding volume" process. This is similar to expansion for first volume, with an additional check of shell position with bounding volume.

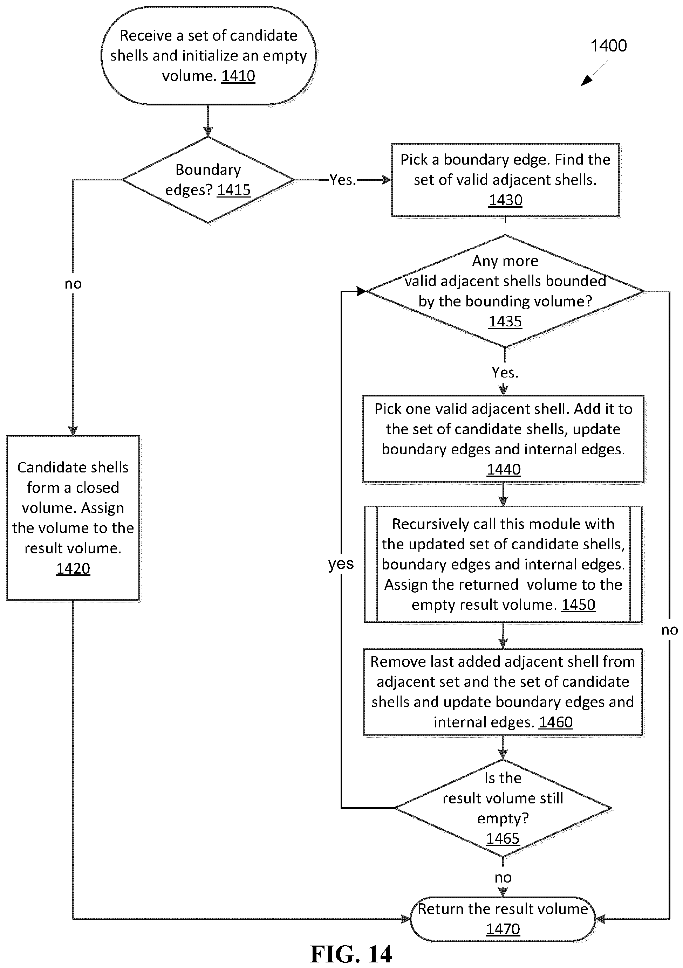

FIG. 14 is a flowchart 1400 for an exemplary embodiment of a method for expansion with bounding volume. The module receives a source shell $S \in L_S$ a current candidate set $L_C$, a boundary edge set BOUNDARY($L_C$), an internal edge set INTERNAL($L_C$),a bounding volume $V_b$ whose shells are SHELLS($V_b$) and a search direction D. If D is -1, the expansion uses only shells inside or on the bounding volume $V_b$. If D is 1, then the expansion uses only shells outside or on the bounding volume $V_b$. The module initializes an empty result volume V, as shown by block 1410.

If there are no boundary edges, i.e., BOUNDARY($L_C$) = Ø, then the candidate shells $L_C$ can form a closed shell. The module sets the result volume V = VOLUME($L_C$), SHELLS(V) = $L_C$, as shown by block 1420, and the module returns the result volume, as shown by block 1470. Returning to block 1415, if there are boundary edges (BOUNDARY($L_C$) ≠ Ø), a boundary edge E $\in$ BOUNDARY($L_C$) is selected, and all the valid adjacent shells VALIDADJACENT(E), are collected, as shown by block 1430. The module determines whether there are any valid adjacent shells bounded by the bounding volume, as shown by block 1435.

If there are no valid adjacent shells VALIDADJACENT(E) = Ø, the module returns the result volume, as shown by block 1470. If there are valid adjacent shells bounded by the bounding volume, an adjacent shell $S_a \in$ VALIDADJACENT (E) is picked and added to the candidate set $L_C = L_C$ U {$S_a$}, as shown by block 1440, whereupon boundary edges are updated with **Error! Reference source not found.** and internal edges are updated with **Error! Reference source not found..** The adjacent shell is picked by the following rules.

If D is -1 and VALIDADJACENT(E) $\cap$ INSIDE($V_b$) ≠ Ø, pick $S_a \in$ VALIDADJACENT(E) $\cap$ INSIDE($V_b$);
If D is -1 and VALIDADJACENT(E) $\cap$ INSIDE($V_b$) = Ø, pick $S_a \in$ VALIDADJACENT(E) $\cap$ SHELLS($V_b$);
If D is +1 and VALIDADJACENT(E) $\cap$ OUTSIDE($V_b$) ≠ Ø, pick $S_a \in$ VALIDADJACENT(E) $\cap$ OUTSIDE($V_b$);
If D is +1 and VALIDADJACENT(E) $\cap$ OUTSIDE($V_b$) = Ø, pick $S_a \in$ VALIDADJACENT(E) $\cap$ SHELLS($V_b$).

The module recursively call itself with the source shell S updated candidate set $L_C$ and updated boundary edges and updated internal edges, as shown by block 1450, and assign the returned result to the result volume V.

The adjacent shell $S_a$ is removed from the adjacent set VALIDADJACENT(E) = VALIDADJACENT(E) - {$S_a$}, as shown by block 1460. The added adjacent shell $S_a$ is removed from the candidate set $L_C$ i.e.,$L_C = L_C$ - {$S_a$}, boundary edges are updated with Eq. 6, and internal edges are updated with **Error! Reference source not found..** The module checks if the volume V is empty, as shown by block 1465. If volume V is not empty, the module returns the result volume, as shown by block 1470. If volume V is empty, control returns to block 1435 to process the next adjacent shell.

Given a source shell, it is an iterative process to find and use bounding volumes until minimum volumes are reached. The module utilizes the geometry relationship between shells and bounding volumes to gradually narrow down the expansion scope. At least one shell can be removed at a time of narrowing expansion scope. For one source shell, with linear time, a minimum volume should be found. If there are n shells to search in total, then the complexity of the main search algorithm to find all minimum volumes is $O(n^2)$.

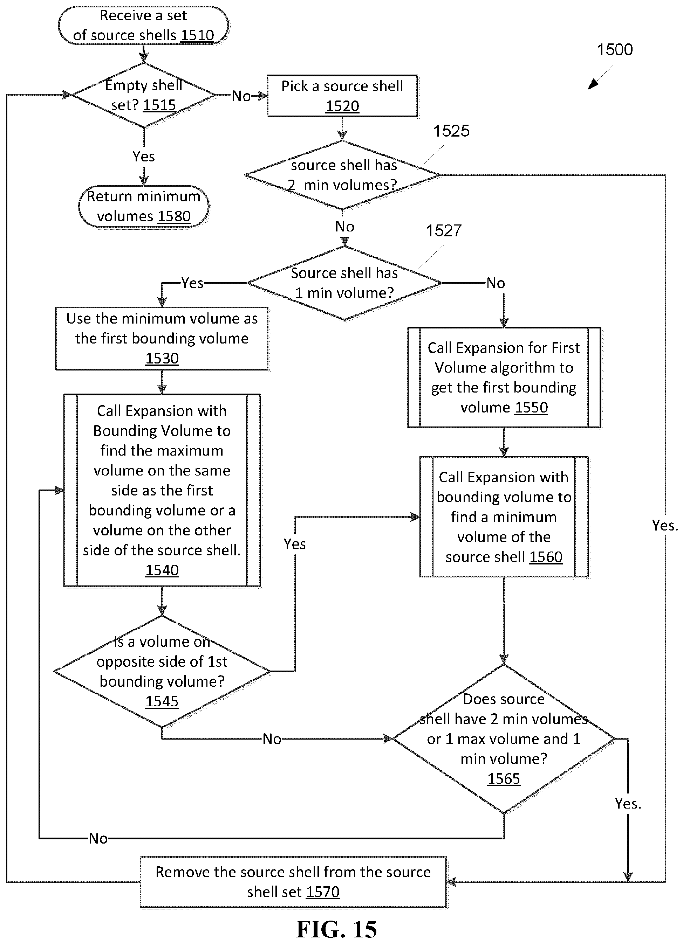

FIG. 15 is a flowchart 1500 for an exemplary embodiment of a fast minimum volume search method. A source shell set $L_S$ is received, as shown by block 1510 and checked for being an empty shell set, as shown by block 1515. If $L_S$ = Ø is an empty set, the method returns minimum values, as shown by block 1580. Otherwise, a source shell $S \in L_s$ is picked, as shown by block 1520. If the source shell already has two minimum volumes (block 1525) the source shell is removed, as shown by block 1570, and the method returns to block 1515. If there is only one minimum volume (block 1527), a bounding volume $V_b$ is initialized as having the minimum volume, as shown by block 1530. If there is not one minimum volume (block 1527), a candidate set $L_C = \{S\}$ is initialized with boundary edges $BOUNDARY(L_C)$ and internal edges $INTERNAL(L_C)$, and the "Expansion for First Volume" module (see FIG. 13) is invoked, as shown by block 1550 with the source shell S, candidate set $L_C$, boundary edges $BOUNDARY(L_C)$ and internal edges $INTERNAL(L_C)$. The returned result volume is $V_1$. The bounding volume $V_b = V_1$ is initialized. The candidate set $L_C = \{S\}$ is reinitialized with boundary edges $BOUNDARY(L_C)$ and internal edges $INTERNAL(L_C)$.

The expansion with bounding volume module (FIG. 14) is invoked, as shown by block 1560 with the source shell S, candidate set $L_C$, boundary edges $BOUNDARY(L_C)$ and internal edges $INTERNAL(L_C)$, bounding volume $V_b$ and the direction D = -1. The returned result volume is $V_r$. If $V_r$ and $V_b$ are different, then update $V_b = V_r$. If $V_r$ and $V_b$ are the same, then $V_r$ is one of the minimum volumes of S. The volume setting module (FIG. 11) is called to update minimum volumes for all the shells $SHELLS(V_r)$. If S already has two minimum volumes (block 1565), the method proceeds to block 1570. Otherwise, the bounding volume $V_b = V_1$ and the candidate set $L_C = \{S\}$ is reinitialized with boundary edges $BOUNDARY(L_C)$ and internal edges $INTERNAL(L_C)$.

As shown by block 1540, the Expansion with Bounding Volume module (FIG. 14) is called with the source shell S, candidate set $L_C$, boundary edges $BOUNDARY(L_C)$ and internal edges $INTERNAL(L_C)$, bounding volume $V_b$ and the direction D = +1. The returned result volume is $V_r$. If $V_r$ and $V_b$ are different but still on the same side of S, then bounding volume is updated $V_b = V_r$. If $V_r$ and $V_b$ are the same, then $V_r$ is the maximum volume of S and there is only one minimum volume. If $V_r$ and $V_b$ are on different sides of S, the bounding volume is set $V_b = V_r$.

With the foregoing volume search algorithm, the whole algorithm of automatic volume generation in Trim Surface feature are still divided into four functional steps, as per FIG. 12. In the fourth step, the algorithm of Fast Minimum Volume Search is used instead of the algorithm of Finding Minimum Volumes. The former converges quickly with polynomial time complexity while the latter tries all available cases slowly with exponential complexity.

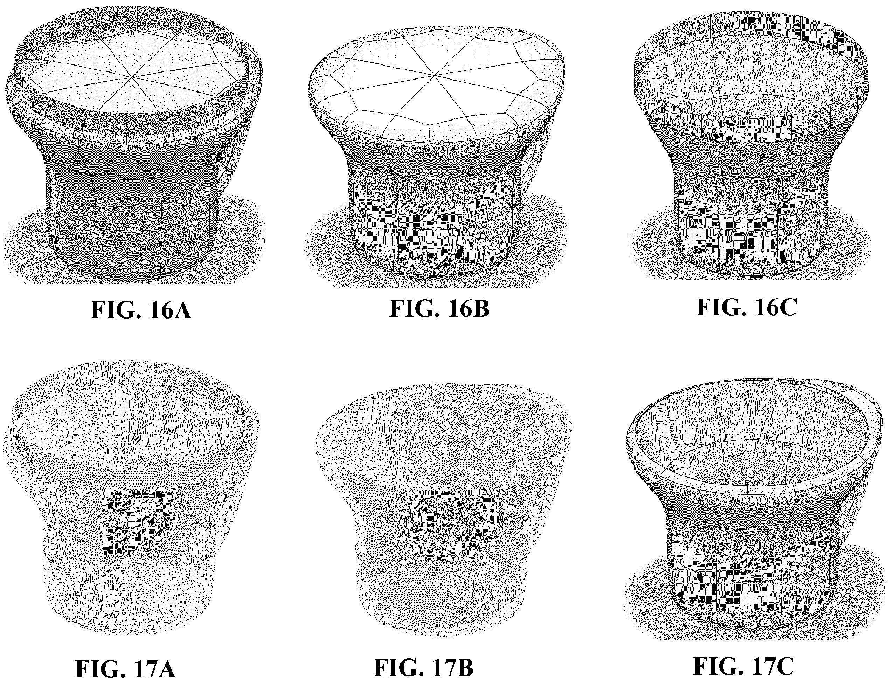

One example shown by FIG. 16A shows a coffee cup model with one closed shell as the cup base (FIG. 16B) and one interior surface (FIG. 16C) to cut the inside of the cup. Trim Surface feature produces split faces in FIGS. 17A-17B. After shell creation and shell pruning, the top shell is removed (FIG. 17C). Through finding volume algorithm, there are two volumes left. If the interior one is removed by users, then the outer volume is a coffee cup.

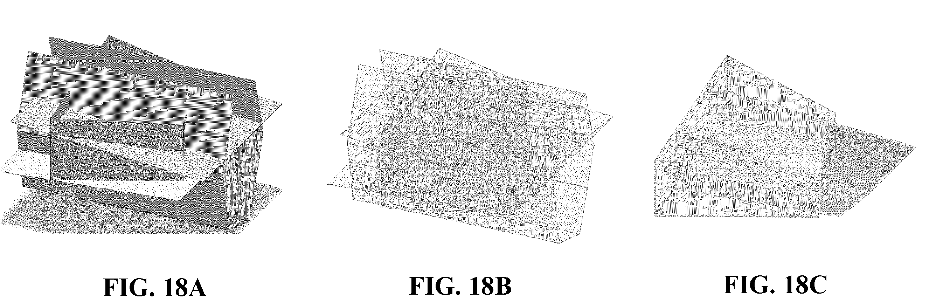

A second example (FIG. 18A) has four surfaces to enclose a special part. They have intersection curves with each other. There are many faces overlapping on the screen after the split and it may be confusing to users to determine what faces to keep (FIG. 18B). After applying the volume generation method, there are four volumes clearly laid out on the screen (FIG. 18C). A user may decide what volumes to remove and what volumes to keep.

A third example **(Error! Reference source not found.)** shows a trim process with three cylindrical shells. The cylindrical shells are placed along x, y, z directions. There are 8 small volumes automatically generated from 14 split shells in this case.

Users have the freedom to pick any combinations from all the small volumes. For example, the automatically generated volumes may be presented to the user by indicating the identified volumes in user display of the modeled component, and/or the identified volume may be presented in a component list, for example in a side-bar to the graphical window presenting a 2D or 3D rendering of the modeled object. The user selection of an automatically generated volume may be, for example, by a user click on a highlighted volume displayed by the graphical interface, or by a user click on the corresponding volume listed in the component list, for example, presented in the same color as corresponding highlighted volume.

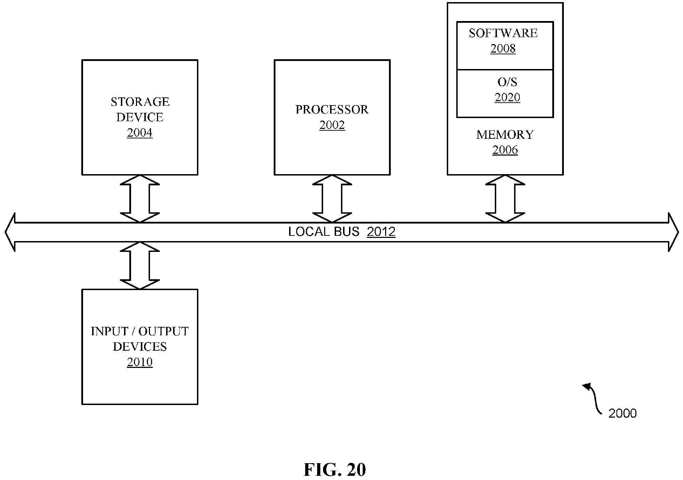

The present system for executing the functionality of the modules and sub-modules described in detail above may be a computer, an example of which is shown in the schematic diagram of FIG. 20. The system 2000 contains a processor 2002, a storage device 2004, a memory 2006 having software 2008 stored therein that defines the abovementioned functionality, input, and output (I/O) devices 2010 (or peripherals), and a local bus, or local interface 2012 allowing for communication within the system 2000. The local interface 2012 can be, for example but not limited to, one or more buses or other wired or wireless connections, as is known in the art. The local interface 2012 may have additional elements, which are omitted for simplicity, such as controllers, buffers (caches), drivers, repeaters, and receivers, to enable communications. Further, the local interface 2012 may include address, control, and/or data connections to enable appropriate communications among the aforementioned components.

The processor 2002 is a hardware device for executing software, particularly that stored in the memory 2006. The processor 2002 can be any custom made or commercially available single core or multi-core processor, a central processing unit (CPU), an auxiliary processor among several processors associated with the present system 2000, a semiconductor based microprocessor (in the form of a microchip or chip set), a microprocessor, or generally any device for executing software instructions. While FIG. 20 shows the processor as a single unit, alternatively the processor may include two or more processing units distributed across two or more locations, for example, communicating via a communication network in addition to or in place of the local interface 2012.

The memory 2006 can include any one or combination of volatile memory elements (e.g., random access memory (RAM, such as DRAM, SRAM, SDRAM, *etc.)*), volatile memory elements *(e.g.,* a hard drive, a solid state drive (SSD), a flash drive, an optical drive, tape) and nonvolatile memory elements *(e.g.,* ROM, CDROM, *etc.).* Moreover, the memory 2006 may incorporate electronic, magnetic, optical, holographic, and/or other types of storage media. Note that the memory 2006 can have a distributed architecture, where various components are situated remotely from one another, but can be accessed by the processor 2002.

The software 2008 defines functionality performed by the system 2000, in accordance with the present invention. The software 2008 in the memory 2006 may include one or more separate programs, each of which contains an ordered listing of executable instructions for implementing logical functions of the system 2000, as described below. The memory 2006 may contain an operating system (O/S) 2020. The operating system essentially controls the execution of programs within the system 2000 and provides scheduling, input-output control, file and data management, memory management, and communication control and related services.

The I/O devices 2010 may include input devices, for example but not limited to, a keyboard, mouse/trackpad, haptic sensor, touchscreen, scanner, microphone, barcode reader, QR code reader, *etc.* Furthermore, the I/O devices 2010 may also include output devices, for example but not limited to, a printer, display (2D, 3D, virtual reality headset), transducer, etc. Finally, the I/O devices 2010 may further include devices that communicate bidirectionally via both inputs and outputs or a combined interface such as a full duplex serial bus (for example, a universal serial bus (USB)), for instance but not limited to, an interface for accessing another device, system, or network), a wireless transceiver, a copper, optical or wireless telephonic interface, a bridge, a router, or other device. The outputs may include an interface to control a manufacturing device, such as a 3D printer, a computerized numerical control (CNC) machine, and/or a milling machine, among others.

When the system 2000 is in operation, the processor 2002 is configured to execute the software 2008 stored within the memory 2006, to communicate data to and from the memory 2006, and to generally control operations of the system 2000 pursuant to the software 2008, as explained above.

It will be apparent to those skilled in the art that various modifications and variations can be made to the structure of the present invention without departing from the scope or spirit of the invention. In view of the foregoing, it is intended that the present invention cover modifications and variations of this invention provided they fall within the scope of the following claims and their equivalents.

**Claims**

1. A computer-based method for automatic volume generation during trim setting of a modeled object comprising a plurality of intersecting faces in a computer aided drafting (CAD) environment, comprising steps of:

   receiving geometric data for each of the plurality of intersecting faces (1210);
   computing an intersecting curve for the intersection of each of the plurality of intersecting faces (1220);
   splitting the plurality of intersecting faces along the intersection curves to produce a plurality of split faces;
   creating a plurality of expanded shells by merging manifold edges of the plurality of split faces (400);
   removing shells comprising non-boundary edges from the plurality of expanded shells (500) to produce a plurality of pruned expanded shells;
   identifying a plurality of minimum volumes formed by the plurality of pruned expanded shells (900); and
   indicating the plurality of minimum volumes on a graphical user display.

2. The method of claim 1, further comprising receiving a user selection of a minimum volume of the plurality of minimum volumes.

3. The method of any one of claims 1 to 2, wherein creating the plurality of expanded shells, further comprises steps of:

   creating a first plurality of shells from the plurality of split faces connected by their respective faces;
   identifying shells with manifold boundary edges in the first plurality of shells; and
   merging the shells with manifold boundary edges to expand the first plurality of shells to form a plurality of expanded shells.

4. The method of any one of claims 1 to 3, wherein identifying a plurality of minimum volumes formed by the plurality of pruned expanded shells further comprises steps of:

   identifying a first minimum volume and a second minimum corresponding to a first and second side of each of the plurality of pruned expanded shells (930); and
   identifying the smaller of the first minimum volume and the second minimum volume (940).

5. The method of claim 4, wherein identifying a plurality of minimum volumes formed by the plurality of pruned expanded shells further comprises steps of:

receiving a set of source shells from the plurality of pruned expanded shells;
selecting a source shell for expansion (920) from the set of source shells; and
inserting the selected source shell into the set of candidate shells (920).

6. The method of claim 4 or 5, wherein identifying a plurality of minimum volumes formed by the plurality of pruned expanded shells further comprises steps of comparing all combinations of volumes of the plurality of pruned expanded shells.

7. The method of claim 5, wherein identifying a plurality of minimum volumes formed by the plurality of pruned expanded shells further comprises steps of:

identifying a boundary shell used as boundary of an enclosed bounding volume;
determining the boundary shell is outside the bounding volume; and
removing the boundary shell from the set of candidate shells.

8. A computer-program comprising instructions which, when the computer-program is executed by a computer, cause the computer to carry out the method of any one of claims 1 to 7.

9. A computer-readable storage medium having recorded thereon the computer-program of claim 8.

10. A system comprising a processor coupled to a memory, the memory having recorded thereon the computer-program of claim 8.

110

**FIG. 1A**

230 212 130

110 210

211

220 221 120

231

**FIG. 1B**

230 212 130

110 210

211

220 221 120 231

**FIG. 1C**

230 300

210

220

**FIG. 1D**

FIG. 2A

FIG. 2B

FIG. 2C

FIG. 3A

FIG. 3B

FIG. 3C

EP 4 660 863 A1

Set of split faces
410

Create a shell for each face. Mark all
shells unvisited. Initialize an empty set
of result shells.
420

Are all shells
visited?
425

No.

Pick an unvisited shell as a
source shell. Mark it visited.
430

Are
there manifold
boundary edges?
435

No→ Add the source
shell into the set
of result shells.
440

Yes.

Yes

Pick a manifold boundary edge. Merge
the shells sharing the boundary edge
into one source shell.
450

Return set of result shells.
460

400

**FIG. 4**

Set of shells 500

Mark all shells unvisited. 510

Are there unvisited shells? 515

Yes.

Pick an unvisited shell. Mark it visited. 520

Find all the boundary edges of the shell. 530

No.

Remove the shell from the set of shells if there is a laminar boundary edge. 540

Return the set of shells. 550

500

**FIG. 5**

17

**FIG. 6A**

**FIG. 6B**

**FIG. 6C**

**FIG. 6D**

FIG. 7A    FIG. 7B    FIG. 7C

**FIG. 8A**

**FIG. 8B**

**FIG. 8C**

**FIG. 8D**

Receive a set of source shells. Initialization of empty set of volume, volume and candidate map. 910

Is the source shell set empty? 915

No.

Yes

Pick a source shell for expansion. Create an empty set of candidate shells and insert the source shell into it. 920

Invoke "Candidate Shell Expansion" (FIG. 10) to find the left and right minimum volumes expanded from the source shell. Remove the source shell from the set of source shells. 930

Iterate through every shell used for the minimum volumes and invoke "Volume Setting" (FIG. 11) to set the shell and the corresponding minimum volume. 940

Return set of volumes 950

900

**FIG. 9**

Find all boundary and internal edges for candidate shells
1010

Any boundary edges?
1015

—No→ Candidate shells form a closed volume. Call Volume Setting with the volume and the source shell.
1020

Yes.

Pick a boundary edge. Find the set of valid adjacent shells
1030

Return 1070

Any more valid adjacent shells? 1035 —No.

Yes.

Pick one valid adjacent shell. Add it to the set of candidate shells, update boundary edges and internal edges.
1040

Recursively call with the updated set of candidate shells, boundary edges and internal edges.
1050

Remove last added adjacent shell from adjacent set and the set of candidate shells and update boundary edges and internal edges.
1060

1000

**FIG. 10**

Receive a volume and a
shell.
1110

↓

Determine whether the
volume is on the left or the
right of the source shell.
1120

↓

Compare with the existing
volume on the same side
that is saved in the shell to
volume map.1130

↓

Smaller than the
existing one?
1135

Yes ↓          No. →

Replace the existing
volume with the new one
in the map.
1140

↓

Return
1150

1100

**FIG. 11**

Receive faces
1210

Compute intersection
curves.
1220

Split faces along
intersection curves
1230

Shell creation by
expansion across
manifold edges.
400

Prune shells and
remove boundary shells
**500**

Find all minimum
volumes from the rest
shells.
900

End

1200

**FIG. 12**

```
                    ┌─────────────────────┐
                   │  Receive a set of     │                              1300
                   │ candidate shells and  │
                   │ initialize an empty   │                               ↙
                   │   volume. 1310        │
                    └──────────┬──────────┘
                               │
                               ▼
                        ╱─────────────╲              ┌────────────────────────┐
                       ╱   Boundary     ╲──Yes.────▶ │ Pick a boundary edge.   │
                       ╲  edges? 1315   ╱            │ Find the set of valid   │
                        ╲─────────────╱              │  adjacent shells. 1330  │
                               │                      └───────────┬────────────┘
                              no                                   │
                               │                                   ▼
                               │                          ╱────────────────╲
                               │                         ╱    Any more       ╲
                               │                    ┌──▶╱ valid adjacent shells?╲──────┐
                               │                    │   ╲       1335           ╱       │
                               │                    │    ╲────────────────────╱        │
                               ▼                    │              │                   no
       ┌──────────────────┐    │                    │             Yes.                  │
       │ Candidate shells │    │                    │              ▼                    │
       │ form a closed    │    │                    │   ┌──────────────────────────┐    │
       │ volume. Assign   │    │                    │   │ Pick one valid adjacent   │    │
       │ the volume to the│    │                    │   │ shell. Add it to the set  │    │
       │ result volume.   │    │                  yes   │ of candidate shells,      │    │
       │      1320        │    │                    │   │ update boundary edges and │    │
       └────────┬─────────┘    │                    │   │ internal edges. 1340      │    │
                │              │                    │   └─────────────┬────────────┘    │
                │              │                    │                 ▼                  │
                │              │                    │   ┌──────────────────────────┐    │
                │              │                    │   │ Recursively call this      │    │
                │              │                    │   │ module with the updated   │    │
                │              │                    │   │ set of candidate shells,  │    │
                │              │                    │   │ boundary edges and         │    │
                │              │                    │   │ internal edges. Assign the│    │
                │              │                    │   │ returned volume to the    │    │
                │              │                    │   │ empty result volume. 1350 │    │
                │              │                    │   └─────────────┬────────────┘    │
                │              │                    │                 ▼                  │
                │              │                    │   ┌──────────────────────────┐    │
                │              │                    │   │ Remove last added adjacent │    │
                │              │                    │   │ shell from adjacent set   │    │
                │              │                    │   │ and the set of candidate  │    │
                │              │                    │   │ shells and update boundary│    │
                │              │                    │   │ edges and internal edges. │    │
                │              │                    │   │         1360              │    │
                │              │                    │   └─────────────┬────────────┘    │
                │              │                    │                 ▼                  │
                │              │                    │          ╱────────────╲           │
                │              │                    │         ╱   Is the      ╲          │
                │              │                    └────────╲ result volume  ╱          │
                │              │                              ╲ still empty?  ╱           │
                │              │                               ╲   1365      ╱            │
                │              │                                ╲──────────╱             │
                │              │                                     │                   │
                │              │                                    no                   │
                │              │                                     ▼                   │
                │              │                          ╭──────────────────────╮       │
                └──────────────┴─────────────────────────▶  Return the result    ◀──────┘
                                                          │  volume 1370         │
                                                          ╰──────────────────────╯
```

**FIG. 13**

1400

Receive a set of candidate shells and initialize an empty volume. 1410

Boundary edges? 1415

Pick a boundary edge. Find the set of valid adjacent shells. 1430

Any more valid adjacent shells bounded by the bounding volume? 1435

no

Candidate shells form a closed volume. Assign the volume to the result volume. 1420

Yes.

Pick one valid adjacent shell. Add it to the set of candidate shells, update boundary edges and internal edges. 1440

yes

Recursively call this module with the updated set of candidate shells, boundary edges and internal edges. Assign the returned volume to the empty result volume. 1450

no

Remove last added adjacent shell from adjacent set and the set of candidate shells and update boundary edges and internal edges. 1460

Is the result volume still empty? 1465

no

Return the result volume 1470

**FIG. 14**

FIG. 15

FIG. 16C

FIG. 17C

FIG. 16B

FIG. 17B

FIG. 16A

FIG. 17A

FIG. 18A

FIG. 18B

FIG. 18C

FIG. 19C

FIG. 19B

FIG. 19A

FIG. 20

Europäisches
Patentamt

European
Patent Office

Office européen
des brevets

# EUROPEAN SEARCH REPORT

**Application Number**

EP 25 18 1500

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2012/236028 A1 (DESIMONE FRANK [US] ET AL) 20 September 2012 (2012-09-20) <br> * paragraph [0008] - paragraph [0087]; figures 2, 4, 6-8, 11-14 * <br> ----- | 1-10 | INV. <br> G06F30/10 <br> G06T17/10 |
| A | US 8 954 295 B1 (VICKNAIR DWIGHT D [US] ET AL) 10 February 2015 (2015-02-10) <br> * column 2 - column 6 * <br> ----- | 1-10 | |
| A | US 2012/173208 A1 (HOUDOUIN JEAN-MICHEL [FR] ET AL) 5 July 2012 (2012-07-05) <br> * paragraph [0080] - paragraph [0084] * <br> ----- | 1-10 | |

**TECHNICAL FIELDS SEARCHED (IPC)**

G06F
G06T

The present search report has been drawn up for all claims

| Place of search | Date of completion of the search | Examiner |
|---|---|---|
| Munich | 19 August 2025 | Lindner, Anja |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

 

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 18 1500

This annex lists the patent family members relating to the patent documents cited in the above-mentioned European search report.
The members are as contained in the European Patent Office EDP file on
The European Patent Office is in no way liable for these particulars which are merely given for the purpose of information.

19-08-2025

| Patent document cited in search report | Publication date | Patent family member(s) | | Publication date |
|---|---|---|---|---|
| US 2012236028 A1 | 20-09-2012 | US | 8207990 B1 | 26-06-2012 |
| | | US | 2012236028 A1 | 20-09-2012 |
| US 8954295 B1 | 10-02-2015 | NONE | | |
| US 2012173208 A1 | 05-07-2012 | EP | 2474930 A1 | 11-07-2012 |
| | | US | 2012173208 A1 | 05-07-2012 |

EPO FORM P0459

For more details about this annex : see Official Journal of the European Patent Office, No. 12/82